# EUROPEAN PATENT APPLICATION

(11) **EP 4 811 964 A1**
(43) Date of publication of application: **23.09.2026**
(21) Application number: 25164497.7
(22) Date of filing: 18.03.2025
(51) Int. Cl.: H10D 89/60, H01L 23/60, H01L 23/64, H02H 9/04

(54) **AN INTEGRATED CIRCUIT**

(71) Applicant: NXP B.V., 5656 AG Eindhoven (NL)
(72) Inventor: DE RAAD, Gijs Jan, 5656 AG Eindhoven (NL); DEKKER, Harm, 5656 AG Eindhoven (NL); SWANENBERG, Maarten Jacobus, 5656 AG Eindhoven (NL)
(74) Representative: Schmütz, Christian Klaus Johannes

(57) **Abstract**

An integrated circuit for an automotive bus system, comprising: a die; a reference terminal; an input terminal, wherein the reference terminal is spaced apart from the input terminal; and a routing path that comprises an electrostatic discharge mitigation circuit and also provides a galvanic connection between the input terminal and the reference terminal. The routing path comprises a conductive trace on the die; the conductive trace comprises a plurality of sections; the plurality of sections is arranged such that, in use, a first section has a current flow in a first direction, and a second section has a current flow in a second direction; the first direction is opposite to the second direction; and the first section is positioned adjacent to the second section, such that the first and second sections are inductively or electro-magnetically coupled to each other when the current flows through the first and second sections.

## Description

### Field

The present disclosure relates to integrated circuits. In particular to integrated circuits with electro-static discharge requirements, wherein a common-mode choke is not permitted.

### Summary

According to a first aspect of the present disclosure there is provided an integrated circuit, IC, for an automotive bus system, comprising: a die; a reference terminal; an input terminal, wherein the reference terminal is spaced apart from the input terminal; and a routing path that comprises an electrostatic discharge, ESD, mitigation circuit and also provides a galvanic connection between the input terminal and the reference terminal, wherein: the routing path comprises a conductive trace on the die; the conductive trace comprises a plurality of sections; the plurality of sections is arranged such that, in use, a first section of the plurality of sections has a current flow in a first direction, and a second section of the plurality of sections has a current flow in a second direction; the first direction is opposite to the second direction; and the first section is positioned adjacent to the second section, such that the first section and the second section are inductively or electro-magnetically coupled to each other when the current flows through the first section and the second section.

In one or more embodiments: the IC further comprises a die pad, wherein the die pad comprises an electrically conductive material, and the die pad is configured to provide mechanical support to the die.

In one or more embodiments, the routing path further comprises a section of the die pad.

In one or more embodiments, the section of the die pad is connected between the reference terminal and the conductive trace.

In one or more embodiments the IC comprises a plurality of layers, wherein each layer defines a plane.

In one or more embodiments the second section is positioned in a different layer to the first section.

In one or more embodiments the first section is positioned adjacent to the second section such that the first section and the second section at least partially overlap in a direction normal to the planes of the layers.

In one or more embodiments the first section and the second section comprise at least 40%, 50% or 60% of a total length of the routing path.

In one or more embodiments the reference terminal is located on a first side of the die, and the input terminal is located on a second side of the die.

In one or more embodiments the first side and the second side are different sides of the die.

In one or more embodiments the reference terminal is spaced apart from the input terminal by at least 0.5 times a diagonal length of the die.

In one or more embodiments the reference terminal comprises a bond pad.

In one or more embodiments the reference terminal bond pad is spaced apart from the input terminal by a distance at least 2 times the width or diameter of the reference terminal bond pad.

In one or more embodiments: the input terminal is a first input terminal; the routing path is a first routing path configured to provide a galvanic connection between the first input terminal and the reference terminal; and the conductive trace is a first conductive trace.

In one or more embodiments the IC further comprises: a second input terminal, and a second routing path configured to provide a galvanic connection between the second input terminal and the reference terminal.

In one or more embodiments the second routing path comprises a second conductive trace on the die.

In one or more embodiments the second conductive trace comprises a plurality of sections.

In one or more embodiments the plurality of sections of the second conductive trace is arranged such that, in use, a first section of the plurality of sections has a current flow in a third direction, and a second section of the plurality of sections of the second conductive trace has a current flow in a fourth direction.

In one or more embodiments the third direction is opposite to the fourth direction.

In one or more embodiments the first section of the second conductive trace is positioned adjacent to the second section of the second conductive trace, such that the first section and the second section are inductively or electro-magnetically coupled to each other when the current flows through the first section and the second section of the second conductive trace.

In one or more embodiments: the first section of the first conductive trace is connected in parallel to the first section of the second conductive trace.

In one or more embodiments the second section of the first conductive trace is connected in parallel to the second section of the second conductive trace.

In one or more embodiments: the first section of the first conductive trace is the same as the first section of the second conductive trace.

In one or more embodiments the second section of the first conductive trace is the same as the second section of the second conductive trace.

In one or more embodiments the die comprises an internal reference terminal.

In one or more embodiments the IC further comprises a fused lead connected between the reference terminal and the internal reference terminal of the die.

In one or more embodiments the ESD mitigation circuit comprises one or more diodes and / or one or more transistors.

In one or more embodiments the automotive bus network is a controller area network, CAN.

According to a further aspect of the present disclosure, there is provided an automotive bus network comprising any IC disclosed herein.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1a shows an example CAN including two transceiver ICs;
Figure 1b shows an example CAN differential signal which may be transmitted through the network;
Figure 2 shows a current-time plot and a voltage-time plot of an experimentally measured 8kV IEC-61000-4-2 pulse;
Figure 3 shows an example CAN stage with ESD protection devices;
Figure 4a shows an example circuit diagram of a CAN ESD protection network;
Figure 4b shows a simplified diagram of an IC that implements the example circuit diagram of Figure 4a;
Figure 5 shows an example circuit diagram of a CAN ESD protection network according to an embodiment of the present disclosure;
Figure 6 shows a comparison between two methods for providing adjacent conductive traces within an IC;
Figure 7 shows an example IC that implements the circuit diagram of Figure 5, according to an embodiment of the present disclosure; and
Figure 8 shows another example IC that implements the example circuit diagram of Figure 5, according to an embodiment of the present disclosure.

### Detailed Description

The following disclosure relates to an integrated circuit (IC) with electro-static discharge (ESD) requirements, and especially where a common-mode choke is not permitted. This requirement is commonly applied to automotive bus systems, among other applications. Automotive bus systems are typically used to enable electronic systems in cars to communicate with each other. There are many examples of automotive bus system commonly in use today, such as controller area networks (CAN), ethernet and local interconnect networks (LIN), for example.

For the sake of clarity and consistency, the embodiments presented herein will be presented in relation to CAN, although it will be understood that these techniques can be applied equally well to each other type of automotive bus system, and indeed ICs with ESD requirements wherein common-mode chokes are not permitted in general.

Communication in CAN systems, and indeed automotive bus systems in general, occurs by way of transceiver ICs. An example of such communication could be a sensor in the windshield detecting moisture and sending a signal to a control unit, followed by the control unit sending a command to the motor driving the windshield wipers to activate. The signals sent out and received by the transceiver IC travel through cables within the car from the sending transceiver to the receiving transceiver.

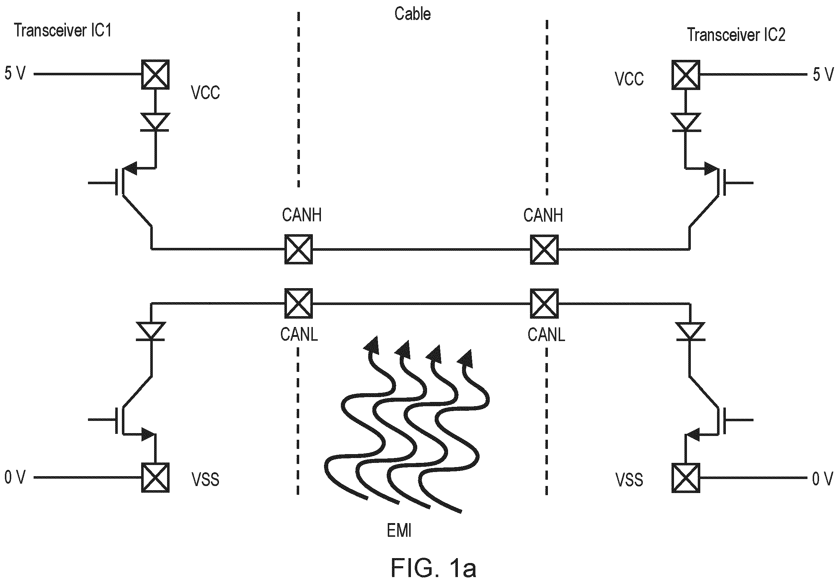

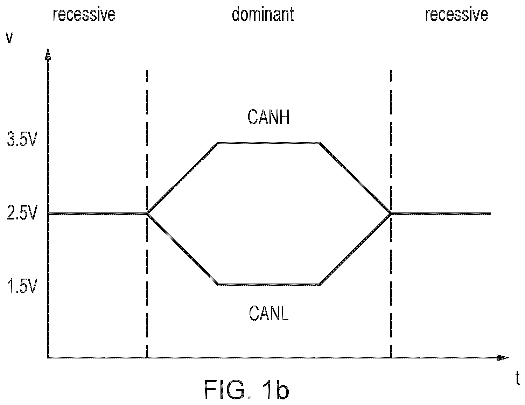

Figure 1a shows an example CAN including two transceiver ICs, and Figure 1b shows an example CAN differential signal which may be transmitted through the network.

Any CAN transceiver IC has (at least) one pair of special pins: the CANL pin and CANH pin. These pins connect to the signal cables that link the transceiver ICs and transmit / receive the signals that the electrical system of the car, as a whole, depends upon to function as designed. At the same time, the transceiver ICs must meet a number of requirements if the CAN communication network is to meet regulatory functional and safety demands:
1) The transmitter stage of the CAN transceiver IC must be able to produce the electrical signal as specified by the CAN protocol (that is, the IC must be able to transition from "recessive" to "dominant" and back within a certain time, etc). As shown in the example CAN differential signal of Figure 1, the recessive state is where two cables have the same voltage (for example, in the recessive state, both CANH and CANL are at 2.5V) and the dominant state is where two cables have a different voltage (for example, in the dominant state, CANH is at 3.5V and CANL is at 1.5V).
2) The network must be immune to electro-magnetic interference (EMI) up to the GHz range, even where the CAN signal itself is only in the MHz range). The communication scheme involving the dominant and recessive states is designed to meet this criterion.
3) The network must be able to withstand up to 40 V - 60 V DC without incurring physical damage (the CAN signals themselves are ~ 5 V). The transistors and diodes used for the CAN stage have a 40 V - 60 V rating for this reason.
4) The CANL and CANH pins of the transceiver IC must be able to withstand an "IEC-61000-4-2" pulse, or "system level ESD" pulse, without sustaining physical damage to the transceiver IC. The IEC-61000-4-2 pulse is designed to replicate a charged person discharging, by way of a metal tool, to a system in a system end user environment wherein the person has not taken any ESD precautions.

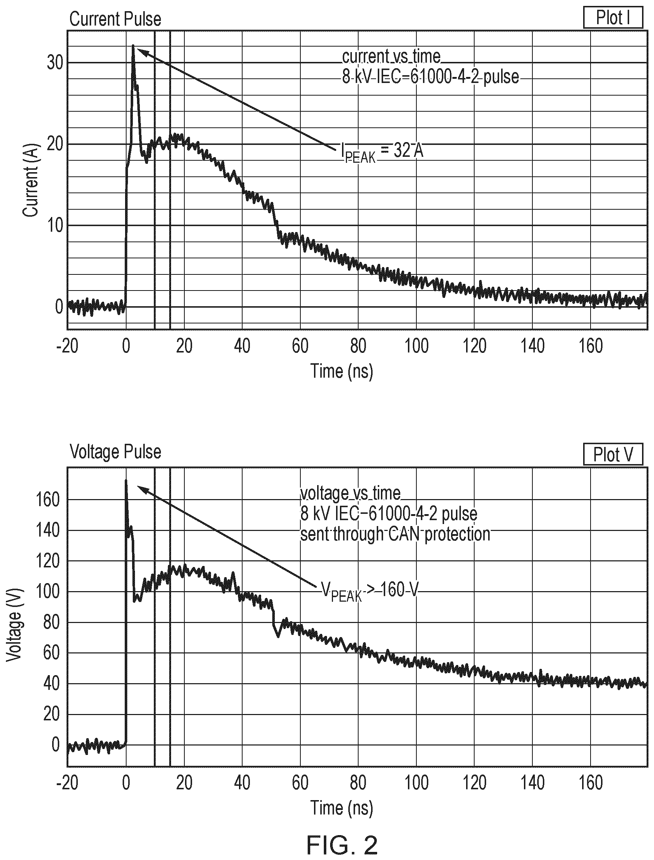

Figure 2 shows a current-time plot and a voltage-time plot of an experimentally measured 8kV IEC-61000-4-2 pulse. The measured 8kV IEC-61000-4-2 pulse is not identical to the IEC standard as it includes a number of artefacts (such as is visible at approximately 55 ns) originating from the equipment and techniques used. These artifacts do not meaningfully impact the results of the test, or the mitigation techniques required. Although actual peak values of these pulses can vary, in many cases an IEC-61000-4-2 pulse has a first peak of about 32A, lasting for about one nanosecond (1ns), followed by a second peak of about 20A occurring about 20ns after the first peak. The current waveform usually has approximately the same shape regardless of the device that the pulse is sent through. The voltage waveform on the other hand depends on the current waveform as well as on the behaviour of the device that the pulse is sent through. Notice that as the current reaches its peak value of 32 A, there is more than 160 V dropped across the CAN pin being tested.

Embodiments of the present disclosure pertain to the additional on-chip circuitry that protects the CANL and CANH pins from the effects of an IEC-61000-4-2 pulse. More specifically, they can pertain to an improvement to a CAN-stage ESD protection network so that it becomes more effective at protecting the devices making up the CAN-stage itself from the effects of the first peak (of approximately 32A and 1ns) of an IEC-61000-4-2 pulse.

As shown in Figure 2, a very substantial voltage drop can build between the CAN pin of the transceiver IC being tested and the ground node of the same IC, when the IC is subjected to IEC-61000-4-2 pulses. This voltage drop may result in voltage stress put on internal devices of the transceiver IC, most notably the devices that make up the CAN-stage.

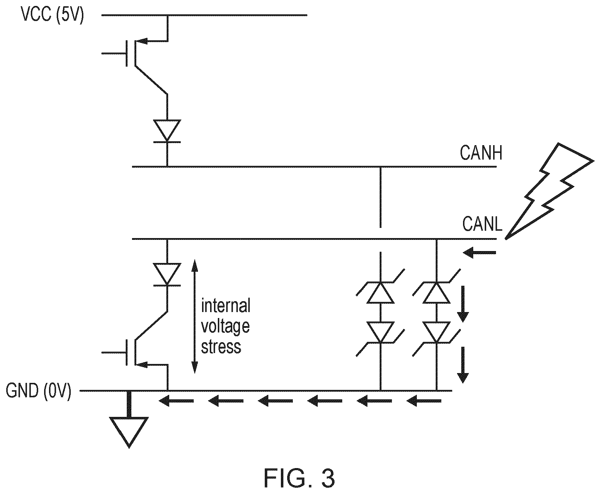

Figure 3 shows an example CAN stage with ESD protection devices. In this example, the ESD protection devices provide bi-directional snapback ESD protection, and are represented in the figure with anti-series Zener diodes, but other devices are possible. The lightning bolt, arrows and ground (GND) symbol indicate the flow of an ESD current through the protection devices and ground network under a positive IEC-61000-4-2 pulse on CANL. As the current flows from CANL to GND via its intended path, a voltage drop builds over different parts of the transceiver IC, resulting in internal voltage stress on some of the internal components, represented in Figure 3 as a double-sided arrow across a diode and transistor which are coupled between CANL and GND.

Part of the above-mentioned voltage drop is caused by the electrical behaviour of the ESD protection devices as they sink the ESD current from one of the CAN-pins to ground. Another part results from a voltage drop building across the metal traces that carry the ESD current from one part of the IC to another. In Figure 3, the current causing this voltage drop across the metal traces is depicted as the horizontal arrows running along the ground trace. It will be understood that such voltage drops can also occur on traces belonging to electrical nodes other than the ground node.

If the voltage stress exerted on the internal devices that make up the CAN-stage exceeds a critical limit, this can result in a failure of that internal device. Under this circumstance, the CAN-stage becomes dysfunctional. For the CAN-stage ESD protection network to function as intended, it is therefore imperative that it not only sinks the IEC-61000-4-2 current pulse, but that it also keeps the peak value of the voltage drop between the CAN pin and the ground node below a critical value, while sinking the ESD pulse.

The voltage drop that builds across some of the IC metal tracks as the current associated with the IEC-61000-4-2 pulse flows from one of the CAN pins to GND, has two components. There is a resistive component, and an inductive component (V = I*R + L*(dI/dt)).

During the first peak of an 8kV IEC-61000-4-2 pulse, the peak current of the first peak is 32A. A resistance of the metal track within an example IC may be approximately 1.3Ω, and a typical inductance of the metal track is approximately 2nH. Therefore, the resulting voltage drop as the first current pulse peaks, should be approximately 42 V (32A * 1.3Ω). At the same time, the current increase from the start of the first pulse to the moment where the first pulse peaks, is roughly 32A across 1ns, that is, 32 GA/sec. The inductive voltage drop across the metal tracks, in this example, is expected to be 2 nH * 32 GA/sec, equalling 64 V. Therefore, given that an IEC-61000-4-2 pulse involves an extremely high current pulse occurring over a very short duration, inductive effects contribute significantly to the overall voltage stress experienced by the internal components in the CAN stage. In fact, the voltage stress resulting from inductive effects may exceed the voltage stress resulting from metal track resistance, as is indeed the case in this example.

CAN transceivers have been used across many different automotive applications for many years, and the design of cars and transceivers have evolved together. This means that addressing the above-described problem by implementing a complete redesign of a CAN transceiver IC would likely also necessitate a corresponding redesign of the surrounding architecture of the implementation. This could be extremely costly, and potentially increase the risk of encountering new problems. Therefore, it is beneficial to address the above-mentioned problem without needing to disrupt the fundamental transceiver IC design principles, which are presently adhered to.

For example, the apparatus disclosed herein may be directed towards embodiments wherein a reference terminal is located on a first side of a die, and an input terminal is located on a second side of the die, wherein the first side and the second side are different sides of the die. That is, wherein the reference terminal and input terminal are located on opposite sides of the die.

In another example, the apparatus disclosed herein may be directed towards embodiments wherein the reference terminal is spaced apart from the input terminal by at least 0.5 times a diagonal length of the die. In yet another example, the apparatus disclosed herein may be directed towards embodiments wherein the reference terminal includes a bond pad, and the reference terminal bond pad is spaced apart from the input terminal by a distance at least 2 times the width or diameter of the reference terminal bond pad. In another example, the apparatus disclosed herein may be directed towards embodiments wherein the input terminal comprises a bond pad, and wherein the bond pad of the input terminal is the same size as the bond pad of the reference terminal. By now, it will be understood that the apparatus discussed below may be applied to ICs with a variety of existing design principles, and further design principles are contemplated, even if not mentioned directly.

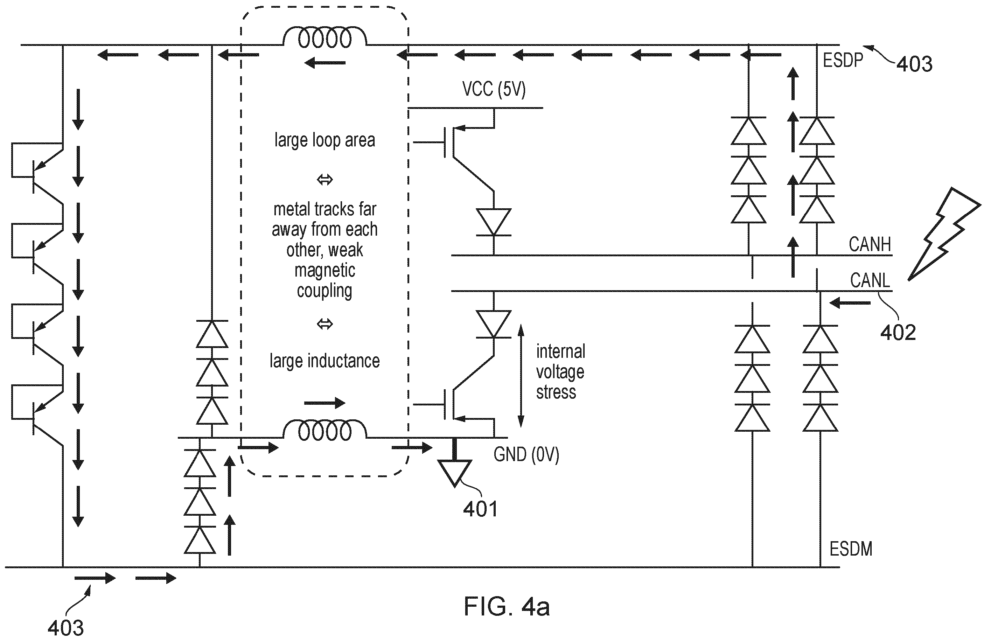

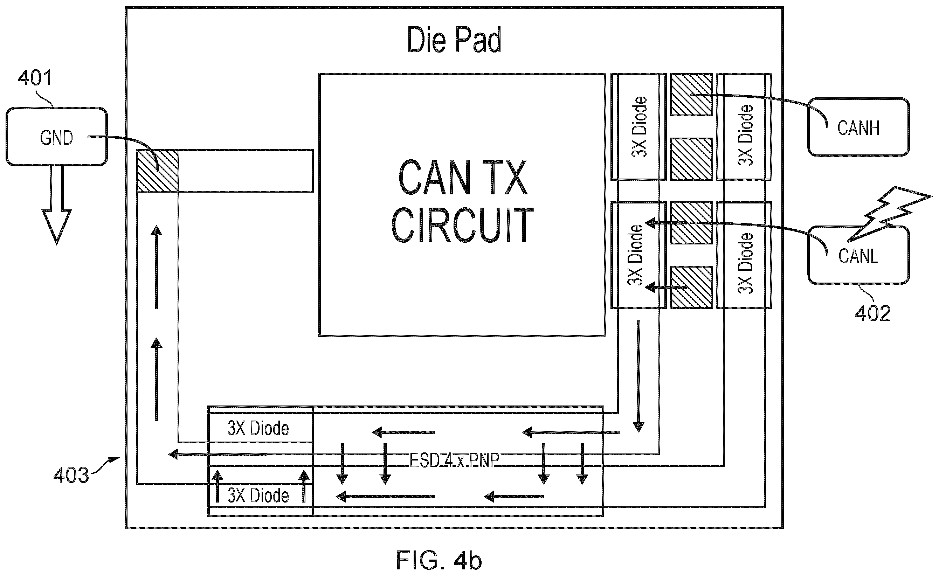

Figure 4a shows an example circuit diagram of a CAN ESD protection network, Figure 4b shows a simplified diagram of an IC that implements the example circuit diagram of Figure 4a. The IC includes a die, a reference terminal 401 (which in this example is a ground terminal) and an input terminal 402 (which in this example is a CANL terminal; it will be appreciated that the CANH terminal on Figure 4b is also an example of an input terminal). The IC also includes a routing path 403 configured to provide a galvanic connection between the input terminal 402 and the reference terminal 401. As is apparent from the figure, the routing path in this example also includes an ESD mitigation circuit, including one or more diodes and / or one or more transistors, for example.

The current flow resulting from a positive (with respect to GND) ESD strike on CANL is indicated by the lightning bolt and arrows through the routing path 403. As is apparent from the above discussion, the inductive effects of the ESD protection network can have a large impact on the internal voltage stress perceived by the internal components. In particular, this is true because of the relative positions of the input terminal 402 and the reference terminal 401, because, in this example, they are located on different sides of the die. This positioning necessitates a longer routing path which results in a greater resistance and inductance across the routing path 403, thereby exacerbating the negative impact of the above-described effects.

However, the inventors have identified a way to mitigate the large voltage stress resulting from the inductive effects of the wires. This is achieved by placing two parallel metal tracks in close proximity to one another such that they experience the same current ramp (dI/dt), but the current flow in one of the lines is in the opposite direction with respect to the current flow in the other metal track. In this way, the inductance effects in one line at least partly cancel out the inductive effects of the other. Therefore, the inventors have found that the inductive component of the voltage stress can be reduced by carefully designing the routing path of the ESD, as will be discussed in detail below.

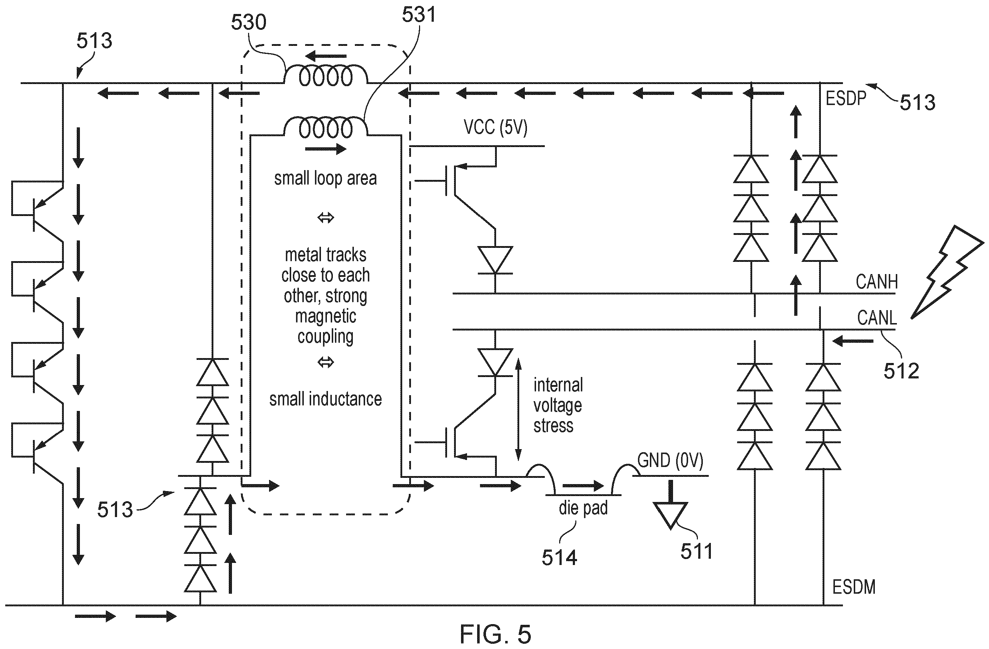

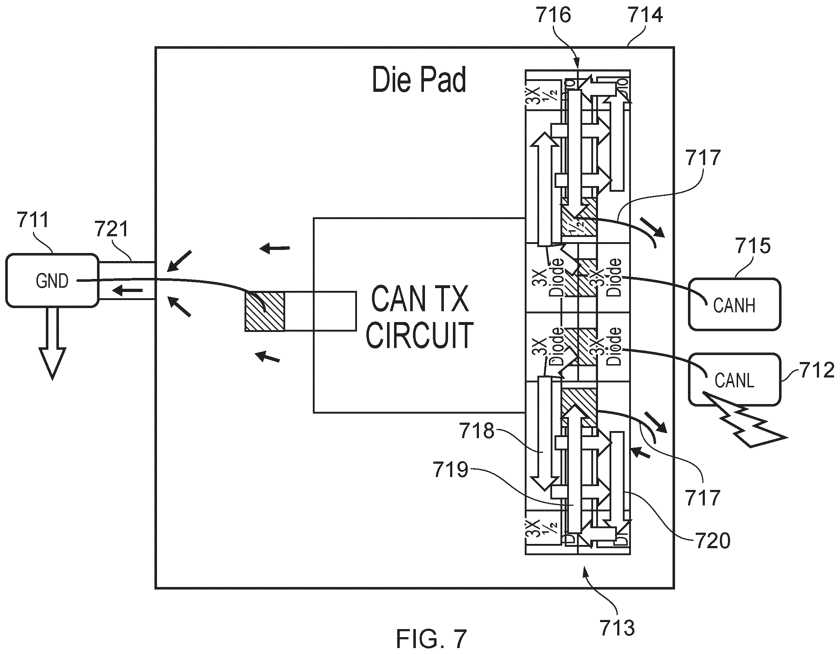

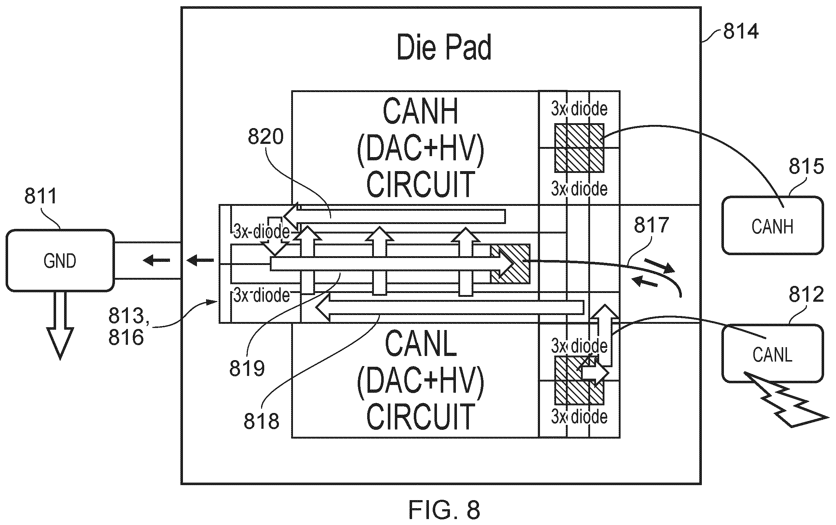

Figure 5 shows an example circuit diagram of a CAN ESD protection network according to an embodiment of the present disclosure. Simplified example ICs that implement the circuit shown in Figure 5 can be seen in Figures 7 and 8 and will be discussed in more detail below. The IC includes a die, a reference terminal 511, and an input terminal 512. The IC also includes a routing path 513 that includes an ESD mitigation circuit and also provides a galvanic connection between the input terminal 512 and the reference terminal 511, via the ESD mitigation circuit. The routing path 513 in Figure 5 is identified by a series of arrows. The ESD mitigation circuit is represented in Figure 5 by a series of diodes and transistors. However, it will be appreciated that other suitable ESD mitigation components may be used.

The routing path 513 includes a conductive trace on the die, which itself includes a plurality of sections. The plurality of sections is arranged such that, in use, a first section of the plurality of sections has a current flow in a first direction, and a second section of the plurality of sections has a current flow in a second direction, wherein the first direction is opposite to the second direction. The first section is positioned adjacent to the second section, such that the first section and the second section are inductively or electro-magnetically coupled to each other when the current flows through the first section and the second section. This arrangement is represented in Figure 5 as an inductive coupling 530, 531, and it can be seen more clearly in Figures 7 and 8, as will be discussed below.

The inductive coupling between the first section and the second section reduces the effective overall inductance of the routing path 513, as the inductive effects experienced by each section are in opposite directions. It follows therefore, if the first and second sections are relatively long when compared to the length of the routing path 513 as a whole, then there is a greater reduction of the inductive effect on the voltage stress. That is, the larger the proportion of the routing path 513 containing adjacent sections with current flow in opposite directions, the greater the protection provided for internal components against the IEC-61000-4-2 pulse is provided by the ESD protection circuit. Therefore, in some embodiments, the first section and the second section comprise at least 40%, 50% or 60% of the total length of the routing path 513.

The adjacent positioning of wires, as discussed above, decreases the total inductive effects of the pair of adjacent sections of wire, but it does not cancel these effects completely. Further, increasing the total length of the wire in the routing path 513, for example to accommodate a routing path with adjacent sections, can also increase the overall inductance of the path. Therefore, it can be beneficial to design the routing path with both factors in mind in order to benefit from the above-described reductions of voltage stress. The factors to consider are expressed mathematically, for a U-shaped section of wire, by the equation: $Δ V = 2 \left(-L+M\right) \frac{dI}{dt}$

In this equation, ΔV is the extra voltage drop expected from inductive effects, dI/dt is the current ramp rate, L is the self-inductance of one half of the U-shaped wire, and M is the mutual inductance that one long side of the U-shaped wire has on the other long side. This equation is to be compared to a single wire (with a length equal to one half of the total length of the U-shaped wire, if it was laid flat), the inductive voltage drop for which is defined by the equation: $Δ V = - L \frac{dI}{dt}$

In the earlier equation, the factor 2 appears because the U-shaped wire is twice as long as the single wire, and it also has the effects of mutual inductance twice since the bottom part of the U-shaped wire acts on the top part, and vice versa. Comparing the two equations shows that, in order to benefit from using a U-shaped current path over a straight one, the layout must be constructed such that the mutual inductance M of the U-shaped wire is at least half of the self-inductance L of the corresponding straight wire. Under these circumstances, the effects of mutual inductance compensate for the additional self-inductance introduced by lengthening the wire.

In IC design, conductive traces intended for routing ESD currents are typically wider than they are thick. Therefore, the strength of mutual inductive coupling between adjacent wires located within the same layer can be less than the mutual inductive coupling strength that is achievable by positioning the conductive traces in different layers such that they at least partially overlap. This is because the total area of the traces which are directly adjacent in an overlapping design is limited by the width (or diameter) of the traces, and the total area of the traces which are directly adjacent in a side-by-side design is limited by the thickness of the traces.

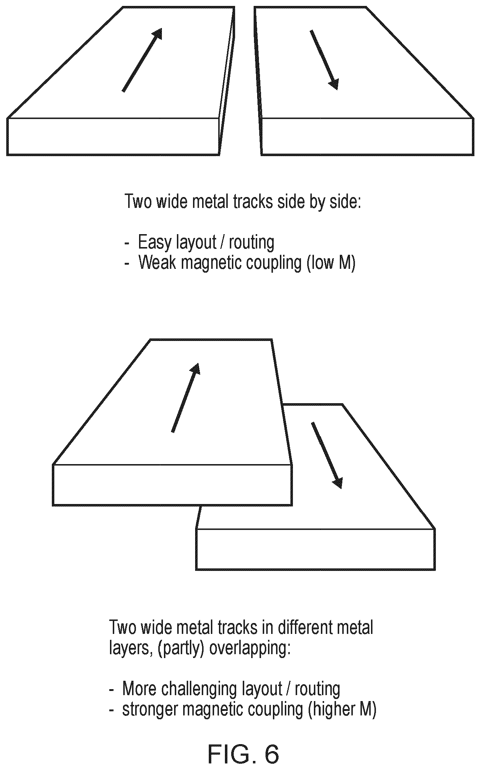

Figure 6 shows a comparison between the two methods for providing adjacent conductive traces within an IC. It is acknowledged within Figure 6 that an overlapping design is more complex to implement than a side-by-side design. For example, vertical connections may be required on each layer, thereby resulting in only a partial overlap of conductive traces.

Therefore, when designing such an IC, the costs and advantages of each design should be considered. For example, if a side-by-side design would provide a sufficient reduction of the inductive voltage drop for the implementation, then there may be no need to produce a more costly design to take advantage of the stronger inductive coupling effects of an overlapping design. Contrastingly, if a side-by-side design would not provide a sufficient inductive voltage drop reduction, then an overlapping design should be considered.

Therefore, in embodiments wherein the IC comprises a plurality of layers, and wherein each layer defines a plane, the second section may be positioned in a different layer to the first section. In these embodiments, the first section may be positioned adjacent to the second section, such that the first section and the second section at least partially overlap in a direction normal to the planes of the layers.

Figure 7 shows an example IC that implements the circuit diagram of Figure 5, according to an embodiment of the present disclosure. The example IC shown in the figure includes a die pad 714, which includes (wholly or in part) an electrically conductive material, and is configured to provide mechanical support to the die. This arrangement is common within IC design and may therefore be exploited without requiring a change to existing IC design principles.

The inventors have identified that the inductive effects felt by the IC may be reduced even further by using a die pad (which is effectively a metal plate) as part of the routing path. This is discussed in more detail below. When a current pulse is sent through a metal plate, the inductive effects (that is, the self-inductance) in the plate are much less than the inductance effects seen in a wire, wherein the length of the wire is equal to the distance that the current travels through the plate. Therefore, in the embodiment shown, the routing path 713 (as identified by the arrows in the figure) includes a section of the die pad 714.

In this embodiment, the IC includes a bond-pad and one or more down-bonds 717 to the die pad 714 to connect an internal reference terminal of the IC to the die pad 714. This facilitates the inclusion of the die pad 714 into the routing path 713. In this way, a current pulse will travel through the one or more down-bonds 717 and then through the die pad 714 from the point(s) of connection of the down-bond(s) 717 to the reference terminal 711, as indicated by arrows on the figure. As a result, the die pad 714 acts as a low resistive, low inductance connection between the down-bond 717 and the reference terminal 711. Further, in this embodiment, the IC includes a fused lead 721, connected between the die pad 714 and the reference terminal 711. The reference terminal 711 may be an IC leadframe pin.

The routing path 713 including a section of the die pad 714 provides a further reduction of the effective inductance of the routing path, resulting in a further decrease in the voltage stress experienced by internal components. As is apparent, the section of the die pad 714 is connected between the reference terminal 711 and the conductive trace, in this embodiment by way of the one or more down-bonds 717. In this embodiment, the die pad 714 is substantially planar, giving rise to the advantages discussed above.

In the same way that is discussed above, the routing path 713 includes a conductive trace on the die, and that the conductive trace includes a plurality of sections, arranged such that, in use, a first section 718 of the plurality of sections has a current flow in a first direction, and a second section 719 of the plurality of sections has a current flow in a second direction.

In this embodiment, the routing path 713 is arranged such that the conductive trace also includes a third section 720 which is arranged such that, in use, the third section 720 of the plurality of sections of the conductive trace has a current flow in the first direction. In this way, the second section 719 is adjacent to both the first section 718 and the third section 720 wherein, in use, current flows in the opposite direction between each adjacent section. This further reduces the effective inductance of the routing path 713.

For the sake of understanding, an example complete current path from the input terminal 712 (which, in this example is the CANL terminal) to the reference terminal 711, through the routing path 713, in an ESD event, as shown in Figure 7, will now be described:
1) An ESD event occurs on the CANL line, wherein a current pulse arrives at the input terminal 712;
2) the current pulse travels from the input terminal 712 to the first section 718 of the conductive trace through a bond wire;
3) the current pulse travels from the first section 718 to the third section 720 of the conductive trace. These sections may, or may not, be in the same IC layer;
4) the current pulse travels from the third section 720 to the second section 719 of the conductive trace. In this example, the second section 719 is in a different layer to the first and third sections 718, 720;
5) the current pulse travels from the second section 719 to a down-bond 717;
6) the current pulse travels from the down-bond 717, by way of a point of connection, to the die pad 714; and
7) the current pulse travels through the die pad 714 to the reference terminal 711.

Although not essential, it is often desirable to provide protection against ESD events on both lines of the differential CAN. Therefore, in this embodiment: the input terminal 712 is a first input terminal (for example, CANL); the routing path 713 is a first routing path configured to provide a galvanic connection between the first input terminal 712 and the reference terminal 711; and the conductive trace (of the first routing path 713) is a first conductive trace. That is, in this embodiment, the above-described routing path 713 is configured to protect the IC against an ESD pulse on the CANL line. The IC also includes: a second input terminal 715 (in this example, CANH), and a second routing path 716 configured to provide a galvanic connection between the second input terminal 715 and the reference terminal 711. The second routing path 716 is equivalent to the first routing path 713, wherein the plurality of sections of the second conductive trace is arranged such that, in use, the first section of the plurality of sections has a current flow in a third direction, and the second section of the plurality of sections of the second conductive trace has a current flow in a fourth direction. Similar to the first and second directions of the first routing path 716, the third direction is opposite to the fourth direction, and the first section 718 of the second conductive trace is positioned adjacent to the second section 719 of the second conductive trace, such that the first section 718 and the second section 719 are inductively or electro-magnetically coupled to each other when the current flows through the first section 718 and the second section 719 of the second conductive trace.

As is apparent from the figure, in this embodiment, the IC includes two distinct routing paths, a first routing path 713 and a second routing path 716, one for each input terminal 712, 715, and each including a conductive trace (making use of the adjacent wire design discussed above) and a section of the die pad 714.

Figure 8 shows another example IC that implements the example circuit diagram of Figure 5, according to an embodiment of the present disclosure. In this embodiment, a central clamp (for example, the string of transistors along the left-hand side of Figure 5) is placed along a centre line of the IC and a ground return line (the second section 819 of the conductive trace) runs between two parallel wires (the first and third sections 818, 820 of the conductive trace) back to the right-hand side of the die where it connects to the die pad 814 with a down-bond 817. In this way, Figure 8 shows an example IC with a routing path 813, 816 as described above. Therefore, regardless of whether an ESD pulse occurs in the CANH or CANL line (thereby arriving at the IC by way of either input terminal 712, 715), the pulse will be routed through the same routing path 813, 816, which provides the inductive advantages which have been discussed above. Thus, it can be said that, in this embodiment, the first section 818 of the first conductive trace is the same as the first section 818 of the second conductive trace, and the second section 819 of the first conductive trace is the same as the second section 819 of the second conductive trace.

The embodiment shown in Figure 8 provides a number of advantages when compared to the embodiment shown in Figure 7. Firstly, the number of required bond-wires and ESD components is reduced, thereby reducing the number of failure points within the IC, and the cost of the device. Secondly, combining the first and second routing paths 813, 816 into one combined path reduces a total amount of die space required for the ESD routing. Depending on the implementation, this may be advantageous in itself, or, in other implementations, the newly-available die space may be used to reduce the metallisation resistance or to increase the length of the conductive traces, such that a greater proportion of the routing path 813, 816 may comprise adjacent wires (thus increasing the voltage stress reduction provided by the routing path 813, 816, as long as the increase of mutual inductance is greater than the increase in self-inductance, as discussed above).

By way of completeness, the example ESD mitigation circuit, included within the routing path, of each of Figures 5, 7 and 8 will now be briefly discussed. The ESD mitigation circuit includes a series connection of:
- a first diode string (comprising a first plurality of diodes, such that the first plurality of diodes is connected in series),
- a transistor string (comprising a plurality of transistors, wherein: each transistor comprises a first terminal, a second terminal and a control terminal, and the plurality of transistors is connected in series, and the control terminal of each transistor is connected to the first terminal of the transistor, such that each transistor is configured to behave as a diode), and
- a second diode string (comprising a second plurality of diodes, such that the second plurality of diodes is connected in series).

In these embodiments, the first diode string, the transistor string and the second diode string are connected in series between the input terminal and the reference terminal, such that, in use, ESD current flows through the ESD mitigation circuit.

In these embodiments, each transistor of the transistor string is a bipolar transistor, and each diode of the first and second pluralities of diodes is a pn junction diode or any other suitable device configured for bipolar diode operation.

In these embodiments, the ESD mitigation circuit also includes a third diode string (comprising a third plurality of diodes, such that the first plurality of diodes is connected in series), and a fourth diode string (comprising a fourth plurality of diodes, such that the fourth plurality of diodes is connected in series). The third and fourth diode strings are connected in series with the transistor string, such that, in use, current flows through the ESD mitigation circuit, and wherein the current either flows through the first and second diode strings or the third and fourth diode strings, depending on the polarity of the current.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An integrated circuit, IC, for an automotive bus system, comprising:
a die;
a reference terminal;
an input terminal, wherein the reference terminal is spaced apart from the input terminal; and
a routing path that comprises an electrostatic discharge, ESD, mitigation circuit and also provides a galvanic connection between the input terminal and the reference terminal, wherein:
the routing path comprises a conductive trace on the die;
the conductive trace comprises a plurality of sections;
the plurality of sections is arranged such that, in use, a first section of the plurality of sections has a current flow in a first direction, and a second section of the plurality of sections has a current flow in a second direction;
the first direction is opposite to the second direction; and
the first section is positioned adjacent to the second section, such that the first section and the second section are inductively or electro-magnetically coupled to each other when the current flows through the first section and the second section.

2. The IC of claim 1, wherein:
the IC further comprises a die pad, wherein the die pad comprises an electrically conductive material, and the die pad is configured to provide mechanical support to the die; and
the routing path further comprises a section of the die pad.

3. The IC of claim 2, wherein the section of the die pad is connected between the reference terminal and the conductive trace.

4. The IC of any preceding claim, wherein:
the IC comprises a plurality of layers, wherein each layer defines a plane;
the second section is positioned in a different layer to the first section; and
the first section is positioned adjacent to the second section such that the first section and the second section at least partially overlap in a direction normal to the planes of the layers.

5. The IC of any preceding claim, wherein the first section and the second section comprise at least 40%, 50% or 60% of a total length of the routing path.

6. The IC of any preceding claim, wherein the reference terminal is located on a first side of the die, and the input terminal is located on a second side of the die, wherein the first side and the second side are different sides of the die.

7. The IC of any preceding claim, wherein the reference terminal is spaced apart from the input terminal by at least 0.5 times a diagonal length of the die.

8. The IC of any preceding claim, wherein the reference terminal comprises a bond pad, and the reference terminal bond pad is spaced apart from the input terminal by a distance at least 2 times the width or diameter of the reference terminal bond pad.

9. The IC of any preceding claim, wherein:
the input terminal is a first input terminal;
the routing path is a first routing path configured to provide a galvanic connection between the first input terminal and the reference terminal;
the conductive trace is a first conductive trace;
the IC further comprises:
a second input terminal, and
a second routing path configured to provide a galvanic connection between the second input terminal and the reference terminal;
the second routing path comprises a second conductive trace on the die;
the second conductive trace comprises a plurality of sections;
the plurality of sections of the second conductive trace is arranged such that, in use, a first section of the plurality of sections has a current flow in a third direction, and a second section of the plurality of sections of the second conductive trace has a current flow in a fourth direction;
the third direction is opposite to the fourth direction; and
the first section of the second conductive trace is positioned adjacent to the second section of the second conductive trace, such that the first section and the second section are inductively or electro-magnetically coupled to each other when the current flows through the first section and the second section of the second conductive trace.

10. The IC of claim 9, wherein:
the first section of the first conductive trace is connected in parallel to the first section of the second conductive trace; and
the second section of the first conductive trace is connected in parallel to the second section of the second conductive trace.

11. The IC of claim 9, wherein:
the first section of the first conductive trace is the same as the first section of the second conductive trace; and
the second section of the first conductive trace is the same as the second section of the second conductive trace.

12. The IC of any preceding claim, wherein the die comprises an internal reference terminal and the IC further comprises a fused lead connected between the reference terminal and the internal reference terminal of the die.

13. The IC of any preceding claim, wherein the ESD mitigation circuit comprises one or more diodes and / or one or more transistors.

14. The IC of any preceding claim, wherein the automotive bus network is a controller area network, CAN.

15. An automotive bus network comprising the IC of any preceding claim.
